# EUROPÄISCHE PATENTANMELDUNG

(11) **EP 3 288 057 A1**
(43) Veröffentlichungstag der Anmeldung: **28.02.2018**
(21) Anmeldenummer: 16185891.5
(22) Anmeldetag: 26.08.2016
(51) Int. Cl.: H01H 47/00, G05B 9/02, H03K 19/007

(54) **SICHERHEITSGERICHTETES SCHALTGERÄT**

(71) Anmelder: Siemens Aktiengesellschaft, 80333 München (DE)
(72) Erfinder: Aufschneider, Klaus, 92278 Illschwang (DE); Lehner, Michael, 92702 Kohlberg (DE); Prölß, Manfred, 92263 Ebermannsdorf (DE)

(57) **Zusammenfassung**

Die Erfindung betrifft ein sicherheitsgerichtetes Schaltgerät (10), das mit einer Magnetspule (12), einer Steuereinheit (20) und einer ersten Schaltvorrichtung (22) ausgestattet ist. Die erste Schaltvorrichtung (22) ist dabei zu einer Aktivierung und Deaktivierung der Magnetspule (12) ausgebildet. Erfindungsgemäß ist die erste Schaltvorrichtung (22) zum Empfangen eines Spulensteuersignals (24), eines Überwachungssignals (32) und eines ersten übergeordneten Steuersignals (26) ausgebildet. Die Erfindung betrifft ferner ein geeignetes Betriebsverfahren (100) für ein solches sicherheitsgerichtetes Schaltgerät (10), ein Programm (80) zur Durchführung eines entsprechenden Betriebsverfahrens (100) und ein Schaltsystem (60), in dem mindestens zwei der sicherheitsgerichteten Schaltgeräte (10) eingesetzt wird.

## Beschreibung

Die Erfindung betrifft ein sicherheitsgerichtetes Schaltgerät und ein dazugehörigen Betriebsverfahren. Die Erfindung betrifft auch ein Programm, mit dem das erfindungsgemäße Betriebsverfahren in einem sicherheitsgerichteten Schaltgerät umgesetzt wird. Darüber hinaus betrifft die Erfindung ein Schaltsystem, in dem das beanspruchte sicherheitsgerichtete Schaltgerät eingesetzt wird.

Aus US 2011/0169345 A1 ist ein Steuerungssystem für einen Elektromotor bekannt, das mit einer speicherprogrammierbaren Steuerung SPS und einem Türschalter verbunden ist. Das Steuersystem weist auch zwei Schütze auf, die separat durch den Türschalter und die SPS angesteuert werden. Durch die SPS wird ferner das vom Türschalter ausgelöste Schaltverhalten eines der beiden Schütze überwacht. Das Steuersystem nach US 2011/0169345 A1 ist darauf gerichtet, die Anforderungen einer Sicherheitskategorie 2 gemäß ISO 13849-1 zu erfüllen.

Nachteilig an den aus dem Stand der Technik bekannten Lösungen ist, dass diese eine hohe Anzahl an Einzelkomponenten mit erheblichem Verdrahtungsaufwand umfassen. Darüber hinaus besteht im Bereich der Automatisierungstechnik Bedarf an einem Schaltgerät und einem Schaltsystem, die ein hohes Maß an Sicherheit bieten, gleichzeitig einfach und wirtschaftlich herstellbar sind, und eine einfache Montage erlauben.

Der Erfindung liegt die Aufgabe zugrunde, ein sicherheitsgerichtetes Schaltgerät bereitzustellen, das die skizzierten Nachteile aus dem Stand der Technik überwindet und in einfacher Weise ein hohes Maß an Sicherheit im Sinne der einschlägigen Normen bietet.

Die Aufgabe wird durch ein sicherheitsgerichtetes Schaltgerät gelöst, das über eine Magnetspule verfügt, über die ein Lastkreis, beispielsweise eine Stromversorgung eines Elektromotors, geöffnet und geschlossen werden kann. Das erfindungsgemäße sicherheitsgerichtete Schaltgerät verfügt auch über eine Steuereinheit, die zum Empfangen, Auswerten und Senden von Signalen geeignet ist. Darüber hinaus verfügt das sicherheitsgerichtete Schaltgerät über eine erste Schaltvorrichtung, die dazu ausgebildet ist, die Magnetspule unmittelbar zu aktivieren und zu deaktivieren. Die Aktivierung und Deaktivierung der Magnetspule erfolgt dabei in Abhängigkeit von Signalen, die die erste Schaltvorrichtung empfängt. Erfindungsgemäß ist die erste Schaltvorrichtung dazu ausgebildet, ein Spulensteuersignal zu empfangen, das über die Steuereinheit erzeugt wird. Gleichermaßen ist die erste Schaltvorrichtung dazu ausgebildet, ein Überwachungssignal zu empfangen, mit dem eine Abweichung der Steuereinheit von einem bestimmungsgemäßen Betriebszustand feststellbar ist. Ferner empfängt die erste Schaltvorrichtung ein erstes übergeordnetes Steuersignal, das von einer dem sicherheitsgerichteten Schaltgerät übergeordneten Steuerinstanz gesendet wird. Die erste Schaltvorrichtung ist dazu ausgebildet, das Spulensteuersignal, das Überwachungssignal und das erste übergeordnete Steuersignal miteinander logisch zu verknüpfen und auf Basis der logischen Verknüpfung zu ermitteln, ob die Magnetspule zu aktivieren ist. Wenn zumindest eines der von der ersten Schaltvorrichtung empfangenen Signale eine Deaktivierung der Magnetspule gebietet, wird ein Deaktivierungssignal an die Magnetspule gesendet.

Durch die Verknüpfung des Spulensteuersignals, des Überwachungssignals und des ersten übergeordneten Steuersignals wird in zahlreichen Betriebsszenarien verhindert, dass ein fehlerhaftes Aktivierungssignal an die Magnetspule gesendet wird. Für den Betrieb der Magnetspule wird dadurch ein hohes Maß an Sicherheit erzielt. Folglich wird das erste übergeordnete Steuersignal in der ersten Schaltvorrichtung durch das Spulensteuersignal von der Steuereinheit bestätigt. Dieses wiederum wird durch das Anliegen des Überwachungssignals bestätigt, das im ordnungsgemäßen Betrieb des sicherheitsgerichteten Schaltgeräts einen bestimmungsgemäßen Betriebszustand der Steuereinheit abbildet. Das sicherheitsgerichtete Schaltgerät greift damit auf Signale zurück, welche in einem sicherheitsgerichteten Schaltgerät für andere Funktionen erzeugt werden. Durch die erste Schaltvorrichtung wird somit auch bei einem Ausfall von Komponenten im sicherheitsgerichteten Schaltgerät eine zuverlässige ordnungsgemäße Aktivierung oder Deaktivierung der Magnetspule erreicht. Zusätzliche Verdrahtungen über die von außen Signale an das sicherheitsgerichtete Schaltgerät gesendet werden, sind bei der erfindungsgemäßen Lösung entbehrlich. Dies erlaubt eine vereinfachte Montage des sicherheitsgerichteten Schaltgeräts in einem Automatisierungssystem.

In einer bevorzugten Ausführungsform des sicherheitsgerichteten Schaltgeräts ist dieses mit einer zweiten Schaltvorrichtung versehen. Die zweite Schaltvorrichtung bildet einen gesteuerten Freilaufkreis aus und ist mit der Steuereinheit und der Magnetspule verbunden. Über den Freilaufkreis wird mittels der Steuereinheit die Stromversorgung der Magnetspule gesteuert. Hierdurch wird das Prinzip eines gesteuerten Freilaufkreises verwirklicht. Die zweite Schaltvorrichtung ist mit der Steuereinheit gekoppelt und dazu geeignet, über einen Deaktivierungsbefehl die Stromversorgung der Magnetspule zu unterbrechen. Mit der zweiten Schaltvorrichtung im Freilaufkreis ist wiederum die Funktionsweise der ersten Schaltvorrichtung überwachbar. Ebenso ist die Funktionsweise der zweiten Schaltvorrichtung durch die erste Schaltvorrichtung überwachbar. Wenn beispielsweise aufgrund eines Fehlers in der ersten Schaltvorrichtung entgegen dem Spulensteuersignal, dem Überwachungssignal und/oder dem ersten übergeordneten Steuersignal weiterhin von der ersten Schaltvorrichtung eine Aktivierung der Magnetspule befohlen wird, so wird dem durch die zweite Schaltvorrichtung entgegengewirkt. Insbesondere wird hierdurch verhindert, dass ein Fehler einer einzelnen Komponente, beispielsweise der ersten Schaltvorrichtung, zu einem Versagen des sicherheitsgerichteten Schaltgeräts insgesamt führt. Die zweite Schaltvorrichtung gehört damit zu einem gesteuerten Freilaufkreis und dient als redundantes Abschaltelement.

Des Weiteren kann das erfindungsgemäße sicherheitsgerichtete Schaltgerät mit einer Empfangseinheit versehen sein, die dazu ausgebildet ist, ein externes Steuersignal zu empfangen, das von der übergeordneten Steuerinstanz gesendet wird. Das externe Steuersignal umfasst zumindest das erste übergeordnete Steuersignal, das an die erste Schaltvorrichtung weitergeleitet wird. Zusätzlich oder alternativ kann aus dem externen Steuersignal auch ein zweites übergeordnetes Steuersignal erzeugt werden, das an die Steuereinheit gesendet wird. Durch die Empfangseinheit erfolgt eine entsprechende Aufbereitung des externen Signals, so dass das erste und/oder zweite übergeordnete Steuersignal in geeigneter Form an die Steuereinheit bzw. die erste Schaltvorrichtung weitergeleitet wird. Das erste und zweite übergeordnete Steuersignal können dabei identisch oder komplementär zueinander ausgebildet sein, so dass das zweite übergeordnete Steuersignal eindeutig aus dem ersten übergeordneten Steuersignal ableitbar ist. Umgekehrt ist auch das erste übergeordnete Steuersignal in eindeutiger Weise aus dem zweiten übergeordneten Steuersignal ableitbar. Hierdurch wird das externe Steuersignal von der Empfangseinheit mehrkanalig erfasst und verarbeitet. Die Steuereinheit ist dazu geeignet, auf Basis des empfangenen zweiten übergeordneten Steuersignals das Spulensteuersignal zu erzeugen. Neben dem zweiten übergeordneten Steuersignal kann bei der Erzeugung des Spulensteuersignals auch ein Konfigurationsdatensatz und/oder Parametersatz berücksichtigt werden, der in der Steuereinheit gespeichert ist. Beispielsweise umfasst der Konfigurationsdatensatz und/oder Parametersatz Informationen über die Größenklasse des sicherheitsgerichteten Schaltgeräts und/oder Codierungsinformationen für das Spulensteuersignal. Mit dem zweiten übergeordneten Steuersignal wird die Konsistenz der von der ersten Schaltvorrichtung empfangenen Signale gewährleistet. Die Empfangseinheit ist dazu ausgebildet, aus dem externen Steuersignal das erste und/oder zweite übergeordnete Steuersignal zu erzeugen und der ersten Schaltvorrichtung und/oder der Steuereinheit zur Verfügung zu stellen.

Die Empfangseinheit erlaubt es damit, ein einkanaliges Signal von der übergeordneten Steuerinstanz in geeigneter Weise dem sicherheitsgerichteten Schaltgerät zur Verfügung zu stellen. In einer Ausführungsform der Erfindung, in der ein zweites übergeordnetes Steuersignal genutzt wird, wird so die zweikanalige Weiterverarbeitung eines einkanaligen externen Steuersignals gewährleistet. Durch die Zweikanaligkeit wird für eine Ansteuerung durch eine externe übergeordnete Steuerinstanz eine Fehlertoleranz von Eins erreicht. Bei einer höheren Mehrkanaligkeit wird eine entsprechend höhere Fehlertoleranz verwirklicht.

In einer weiteren Ausführungsform der Erfindung kann die Empfangseinheit auch derart ausgebildet sein, dass das erste und zweite übergeordnete Steuersignal bereits im externen Steuersignal separat enthalten sind, und somit ein zweikanaliges externes Steuersignal vorliegt. Hierdurch wird eine einfache und gleichzeitig in puncto Sicherheit leistungsfähige Verbindung zur übergeordneten Steuerinstanz hergestellt und dem Auftreten von Fehlerzuständen beim Betrieb der Magnetspule entgegengewirkt. Auch hierdurch wird die mit dem beanspruchten Schaltgerät erzielbare Sicherheit weiter gesteigert.

In einer weiteren vorteilhaften Ausführungsform der beanspruchten Erfindung ist die erste Schaltvorrichtung dazu ausgebildet, die Magnetspule zu deaktivieren, wenn zumindest eines der ankommenden Signale, also das erste übergeordnete Steuersignal, das Spulensteuersignal oder das Überwachungssignal eine Spulendeaktivierung vorgeben. Das erfindungsgemäße sicherheitsgerichtete Schaltgerät basiert darauf, dass ein eintretender Fehlerzustand von zumindest einer der Komponenten des sicherheitsgerichteten Schaltgeräts oder der übergeordneten Steuerinstanz korrekt erkannt wird und eine entsprechende Gegenmaßnahme eingeleitet wird. Die Nutzung des ersten übergeordneten Steuersignals als Kriterium zur Deaktivierung der Magnetspule nutzt die sicherheitsgerichteten Kapazitäten der übergeordneten Steuerinstanz. Die Steuereinheit ist dazu in der Lage, eine Vielzahl an sicherheitsrelevanten Informationen auszuwerten und sicherheitsgerichtet über das Spulensteuersignal auf die Magnetspule einzuwirken. Das Überwachungssignal als Deaktivierungskriterium für die Magnetspule erlaubt es, die Robustheit des Watchdogs nicht nur für den sicheren Betrieb der Steuereinheit, sondern auch für die unmittelbare Aktivierung bzw. Deaktivierung der Magnetspule zu nutzen. Das Auslösen einer Deaktivierung der Magnetspule ist durch eine entsprechende logische Verknüpfung des ersten übergeordneten Steuersignals, des Spulensteuersignals und des Überwachungssignals mit einfachen und zuverlässigen Komponenten möglich. Die Erfindung bietet insgesamt ein hohes Maß an Sicherheitsgewinn bei reduziertem Bauaufwand.

Alternativ kann das erfindungsgemäße sicherheitsgerichtete Schaltgerät auch eine Zusatzsteuereinheit aufweisen, die die Funktionstüchtigkeit der Steuereinheit überwacht. Vorzugsweise ist die Zusatzsteuereinheit bautypengleich mit der Steuereinheit.

Ferner kann dem sicherheitsgerichteten Schaltgerät eine zweite Schaltvorrichtung zugeordnet sein, die auch zu Deaktivierung der Magnetspule dient. Die zweite Schaltvorrichtung ist unabhängig von der ersten Schaltvorrichtung betätigbar und über einen separaten Freilaufkreis mit der Steuereinheit gekoppelt. In einem bestimmungsgemäßen Betrieb wird mittels einer Messvorrichtung die Stromstärke erfasst und die Messdaten an die Steuereinheit weitergeleitet. In der Steuereinheit ist ein Sollwert für die Stromstärke gespeichert, die in der Magnetspule vorzuliegen hat. Der Sollwert ist dabei abhängig von der Baugröße des sicherheitsgerichteten Schaltgeräts und kann beispielsweise über eine Parametrierung in der Steuereinheit eingestellt werden. In der Steuereinheit ist auch ein wählbarer Toleranzwert gespeichert, der bei einem Vergleich des Sollwerts mit den Messdaten von der Messvorrichtung berücksichtigt wird. Wenn die vorliegende Stromstärke in der Magnetspule betragsmäßig um mehr als den wählbaren Toleranzwert vom Sollwert abweicht, wird ein kritischer Zustand der Magnetspule erkannt, beispielsweise ein Überstrom oder ein Unterstrom. Wenn ein kritischer Zustand der Magnetspule erkannt ist, wird durch einen Befehl der Steuereinheit die zweite Schaltvorrichtung derart betätigt, dass die Magnetspule deaktiviert wird, indem deren Stromversorgung unterbrochen wird. Mit dem Freilaufkreis, der die zweite Schaltvorrichtung aufweist, verfügt die Steuereinheit über ein zusätzliches Mittel zur Deaktivierung der Magnetspule.

Die Steuereinheit ist über den Freilaufkreis dazu in der Lage, zur Deaktivierung der Magnetspule zusätzlich zur ersten Schaltvorrichtung auch die zweite Schaltvorrichtung zu betätigen. Dadurch wird ein redundanter Weg zur Deaktivierung der Magnetspule zur Verfügung gestellt. Infolgedessen wird die Betätigungssicherheit des sicherheitsgerichteten Schaltgeräts weiter erhöht.

In einer besonders bevorzugten ausführungsform der Erfindung weisen jeweils die erste oder zweite Schaltvorrichtung einen Halbleiterschalter, insbesondere einen Transistor, einen IGBT oder einen MOSFET und/oder mindestens einen Logikbaustein auf. Dabei handelt es sich um einfache, zuverlässige und kosteneffiziente elektronische Komponenten, die eine besonders wirtschaftliche Herstellung des sicherheitsgerichteten Schaltgeräts erlauben.

Ein Pulsweitenmodulationssignal nimmt abwechselnd einen High-Zustand und einen Low-Zustand ein. Der Übergang zwischen dem High-Zustand und dem Low-Zustand erfolgt mit einer Frequenz, die von der ersten Schaltvorrichtung als Aktivierungssignal an die Magnetspule wahrgenommen wird. Dies wird beispielsweise durch die Ausnutzung der Reaktionsträgheit eines Logikbausteins erreicht. Das Spulensteuersignal kann damit als funktioneller Bestandteil eines vorhandenen Pulsweitenmodulationssignals ausgebildet sein, so dass ein separater Pfad für das Spulensteuersignal entbehrlich ist. Zusätzlich oder alternativ kann das Überwachungssignal als Ausgangssignal eines Watchdogs ausgebildet sein, der mit der Steuereinheit verbunden ist. Die Nutzung des Überwachungssignals für die erste Schaltvorrichtung erfordert damit nur einen minimalen Bauaufwand. Auch hierdurch wird insgesamt die Einfachheit, und damit Robustheit und Wirtschaftlichkeit, des erfindungsgemäßen sicherheitsgerichteten Schaltgeräts gesteigert. Des Weiteren ist ein erhöhtes Wiederholungsprüfintervall von bis zu einem Monat erreichbar.

In einer weiteren bevorzugten Ausführungsform der Erfindung wird mit der Magnetspule ein Lastkreis geöffnet und geschlossen, der eine Leistung von 50 kW bis 750 kW führt. Das erfindungsgemäße sicherheitsgerichtete Schaltgerät ist damit auch für entsprechend große Magnetspulen geeignet, die ein erhöhtes Maß an Antriebsleistung erfordern. Das erfindungsgemäße sicherheitsgerichtete Schaltgerät ist ohne Weiteres an eine breite Spanne an Einsatzzwecken anpassbar und weist ein hohes Maß an Robustheit auf.

Die zugrundeliegende Aufgabenstellung wird auch durch ein Betriebsverfahren für ein sicherheitsgerichtetes Schaltgerät gelöst, das eine Magnetspule aufweist, mit der ein Lastkreis unterbrochen bzw. geschlossen wird. Das sicherheitsgerichtete Schaltgerät weist eine Steuereinheit und eine erste Schaltvorrichtung auf, mit denen die folgenden Verfahrensschritte durchgeführt werden:
In einem ersten Verfahrensschritt wird ein erstes übergeordnetes Steuersignal von der ersten Schaltvorrichtung empfangen, das von einer übergeordneten Steuerinstanz an das sicherheitsgerichtete Schaltgerät gesendet wird. In einem weiteren Verfahrensschritt wird von der ersten Schaltvorrichtung ein Spulensteuersignal empfangen, dass mittelbar oder unmittelbar von der Steuereinheit erzeugt und gesendet wird. Darüber hinaus wird in einem weiteren Verfahrensschritt von der ersten Schaltvorrichtung ein Überwachungssignal empfangen, das von einem Watchdog erzeugt wird. Der Watchdog ist mit der Steuereinheit verbunden und überwacht deren bestimmungsgemäßes Funktionieren. Das Überwachungssignal bildet ab, ob ein bestimmungsgemäßer Zustand der Steuereinheit vorliegt. In einem weiteren Verfahrensschritt wird von der ersten Schaltvorrichtung erfasst, ob zumindest eines der empfangenen Signale eine Deaktivierung der Magnetspule vorgibt. Wenn mindestens eines der empfangenen Signale, also das erste übergeordnete Steuersignal, das Überwachungssignal oder das Spulensteuersignal einen Zustand aufweist, der eine Deaktivierung der Magnetspule gebietet, wird ein Deaktivierungsbefehl von der ersten Schaltvorrichtung an die Magnetspule gesendet.

Im erfindungsgemäßen Betriebsverfahren können die Schritte, in denen das erste übergeordnete Steuersignal, das Spulensteuersignal und das Überwachungssignal von der ersten Schaltvorrichtung empfangen werden, im Wesentlichen gleichzeitig durchgeführt werden. Die Auswertung der an der ersten Schaltvorrichtung eingehenden Signale kann auf einfacher Hardware schnell und zuverlässig durchgeführt werden. Eine zeitliche Koordinierung der Signale untereinander ist nicht erforderlich, so dass das erste übergeordnete Steuersignal, das Spulensteuersignal und das Überwachungssignal in puncto Taktung an ihre anderweitigen Funktionen anpassbar sind. Das erfindungsgemäße Betriebsverfahren bietet einen Zugewinn an Sicherheit, für den die eingesetzten Signale nicht in nachteilhafter Weise zu modifizieren sind. Das beanspruchte Betriebsverfahren kann folglich auch durch eine einfache Nachrüstung bestehender Hardware verwirklicht werden.

In einer besonders bevorzugten Ausführungsform des erfindungsgemäßen Betriebsverfahrens wird in einem zusätzlichen Verfahrensschritt ein Stromfluss durch die Magnetspule mittels einer Messvorrichtung erfasst. Vorzugsweise erfolgt die Erfassung des Stromflusses im Betrieb zyklisch. Wenn der erfasste Stromfluss in der Magnetspule von einem einstellbaren Sollwert abweicht, wird von der Steuereinheit ein Deaktivierungsbefehl an die erste und/oder zweite Schaltvorrichtung gesendet um so die Stromversorgung der Magnetspule zu unterbrechen. Durch die beschriebenen zusätzlichen Verfahrensschritte wird gewährleistet, dass ein Deaktivierungsbefehl im Fehlerfall von zumindest einer der vorhandenen Schaltvorrichtung erfolgreich umgesetzt wird.

Das erfindungsgemäße Betriebsverfahren stützt sich dabei auf ein Minimum von Signalen, die in Schaltgeräten üblicherweise erzeugt werden. Infolge der Einfachheit des erfindungsgemäßen Betriebsverfahrens kann dieses ohne Weiteres auf Hardware mit geringer Rechenleistung umgesetzt werden. Insgesamt wird ein hohes Maß an Betriebssicherheit für ein sicherheitsgerichtetes Schaltgerät mit einem reduzierten Aufwand an Hardware und Firmware erreicht.

Gleichermaßen wird die zugrundeliegende Aufgabenstellung durch ein Programm gelöst, das dazu geeignet ist, auf einer Steuereinheit in einem entsprechenden sicherheitsgerichteten Schaltgerät gespeichert und ausgeführt zu werden. Das Programm ist erfindungsgemäß dazu ausgebildet, mindestens eines der oben zitierten Betriebsverfahren in einem der oben beschriebenen sicherheitsgerichteten Schaltgeräte durchzuführen.

Darüber hinaus wird die Aufgabenstellung auch von einem erfindungsgemäßen Schaltsystem gelöst, das dazu ausgebildet ist, einen Lastkreis zu öffnen oder zu schließen. Das Schaltsystem umfasst dazu eine übergeordnete Steuerinstanz, beispielsweise eine speicherprogrammierbare Steuerung oder ein Sicherheitsschaltgerät, die dazu ausgelegt ist, ein einkanaliges oder ein zweikanaliges externes Steuersignal auszugeben. Die übergeordnete Steuerinstanz ist dazu mit zwei sicherheitsgerichteten Schaltgeräten verbunden, so dass das Schaltsystem eine Hardware-Fehlertoleranz von mindestens Eins aufweist. Die mindestens zwei sicherheitsgerichteten Schaltgeräte bilden jeweils zueinander das entsprechende Reservegerät. Wenn eines der beiden sicherheitsgerichteten Schaltgeräte, beispielsweise infolge eines Kontaktklebens, ausfällt, ist das jeweils andere sicherheitsgerichtete Schaltgerät dazu in der Lage, eine sichere Deaktivierung des Lastkreises durchzuführen. Dadurch wird das Prinzip eines zweikanaligen Aufbaus im erfindungsgemäßen Schaltsystem verwirklicht. Die sicherheitsgerichteten Schaltgeräte im beanspruchten Schaltsystem sind jeweils gemäß einer der oben beschriebenen Ausführungsformen des beanspruchten sicherheitsgerichteten Schaltgeräts ausgebildet. Das erfindungsgemäße Schaltsystem weist insgesamt ein Sicherheits-Integritäts-Level von bis zu SIL3, ein Performance-Level von bis zu PLe und eine Sicherheitskategorie von bis zu 4 auf. Die SIL-Anspruchsgrenze des erfindungsgemäßen Schaltsystems liegt bei bis zu SIL CL3.

Die Erfindung wird im Folgenden anhand von einzelnen Ausführungsbeispielen näher geschildert. Es zeigen:
- FIG 1: den Aufbau einer Ausführungsform des erfindungsgemäßen sicherheitsgerichteten Schaltgeräts;
- FIG 2: den Ablauf einer Ausführungsform des erfindungsgemäßen Betriebsverfahrens;
- FIG 3: den Aufbau einer Ausführungsform des erfindungsgemäßen Schaltsystems.

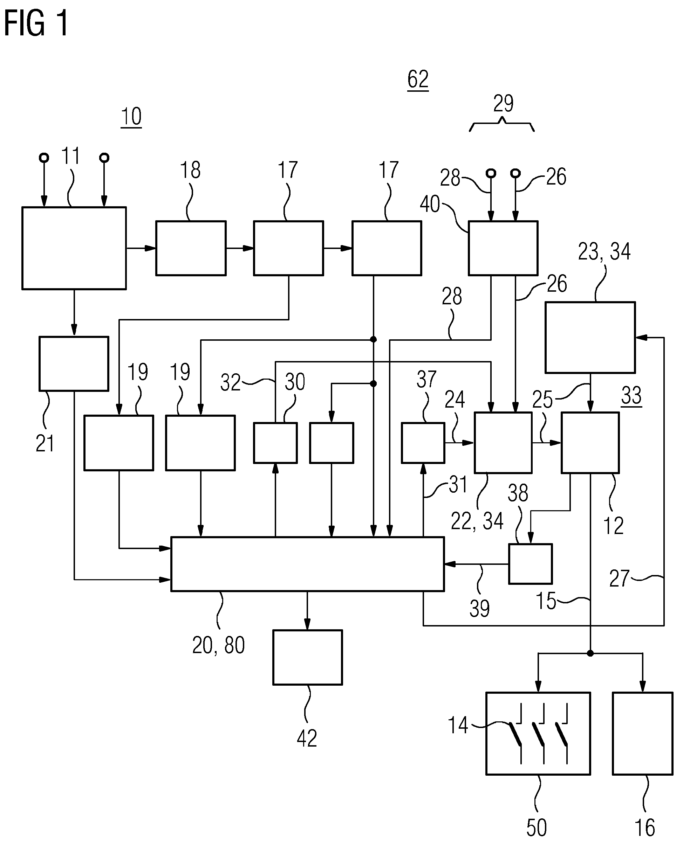

In FIG 1 ist schematisch der Aufbau einer Ausführungsform des erfindungsgemäßen sicherheitsgerichteten Schaltgeräts 10 dargestellt, das an einen Lastkreis 50 angeschlossen ist. Die Stromversorgung des sicherheitsgerichteten Schaltgeräts 10 erfolgt über ein Netzteil 11, das unter anderem den Strom für den Betrieb der einzelnen Komponenten im sicherheitsgerichteten Schaltgerät 10 bereitstellt. Das Netzteil 11 ist mit einem Gleichrichter 18 und einer mehrstufigen Spannungspegelanpassung verbunden. Die angepassten Spannungspegel werden mittels Spannungsmesseinrichtungen 17 überwacht und das Messergebnis an eine Steuereinheit 20 weitergeleitet. Ferner ist das Netzteil 11 mit einem Spannungssensor 21 gekoppelt, mittels dessen Messungen die Pulsweitenmodulation des Spulensteuersignals 24 definiert wird.

Das sicherheitsgerichtete Schaltgerät 10 verfügt über eine Magnetspule 12, die dazu ausgelegt ist, eine elektromagnetische Betätigung einer mechanischen Kopplung 15 zu symbolisch angedeuteten Schaltkontakten 14 durchzuführen. Die Schaltkontakte 14 gehören zum Lastkreis 50, in dem ein erheblich höherer Strom geführt wird als im Schaltgerät 10 selbst. Die Schaltkontakte 14 wirken im Lastkreis 50 mit Hilfskontakten 16 zusammen, die zur Rückmeldung des Schaltzustands der Schaltkontakte 14 dienen. Die Magnetspule 12 ist über eine erste Schaltvorrichtung 22, die einen IGBT 34 aufweist, aktivierbar und deaktivierbar. Die erste Schaltvorrichtung 22 ist mit einem Signalgenerator 37 verbunden, der von der Steuereinheit 20 ansteuerbar ist. Die Steuereinheit 20 ist als Mikrocontroller ausgebildet und dazu geeignet, ein Signal 31 auszugeben, das vom Signalgenerator 37 in das Spulensteuersignal 24 umgesetzt wird. Das Spulensteuersignal 24 ist ein pulsweitenmoduliertes Signal, kurz PWM-Signal, mit dem die von der Magnetspule 12 erzeugte Haltekraft einstellbar ist. Die erste Schaltvorrichtung 22 ist dazu ausgelegt, das Spulensteuersignal 24 zu empfangen und dahingehend zu erfassen, ob eine Aktivierung der Magnetspule 12 befohlen wird oder nicht. Die erste Schaltvorrichtung 22 ist auch dazu ausgebildet ein erstes übergeordnetes Steuersignal 26 zu empfangen, das das sicherheitsgerichtete Schaltgerät 10 über eine Empfangseinheit 40 erreicht. Das übergeordnete Steuersignal 26 wird von einer nicht näher dargestellten übergeordneten Steuerinstanz 62 erzeugt. Ferner ist die erste Schaltvorrichtung 22 dazu ausgelegt, ein Überwachungssignal 32 zu empfangen, das von einem Watchdog 30 gesendet wird. Der Watchdog 30 ist mit der Steuereinheit 20 gekoppelt. Das Überwachungssignal 32 zeigt binär an, ob ein ordnungsgemäßer Betrieb der Steuereinheit 20 vorliegt.

Die erste Schaltvorrichtung 22 überprüft das ankommende Spulensteuersignal 24, das erste übergeordnete Steuersignal 26 und das Überwachungssignal 32 dahingehend, ob eines dieser Signale eine Deaktivierung der Magnetspule 12 vorgibt. Das Überprüfen erfolgt dabei durch eine geeignete logische Verknüpfung der Signale 24, 26, 32. Wenn mindestens eines der Signale 24, 26, 32 eine durchzuführende Deaktivierung der Magnetspule 12 anzeigt, wird von der ersten Schaltvorrichtung 22 ein Deaktivierungsbefehl 25 an die Magnetspule 12 gesendet. Des Weiteren ist die Steuereinheit 20 dazu ausgebildet, ein zweites übergeordnetes Steuersignal 28 zu empfangen. Das erste und zweite übergeordnete Steuersignal 26, 28 gehören zu einem zweikanaligen externen Steuersignal 29, das von der nicht näher abgebildeten übergeordneten Steuerinstanz 62 gesendet wird, die mit dem sicherheitsgerichteten Schaltgerät 10 über die Empfangseinheit 40 verbunden ist. Durch die Empfangseinheit 40 werden das erste und zweite übergeordnete Steuersignal 26, 28 aus dem externen Steuersignal 29 in geeigneter Form für das sicherheitsgerichtete Schaltgerät 10 bereitgestellt. Die Steuereinheit 20 ist dazu in der Lage, die Konsistenz des vorliegenden Betätigungszustands der Magnetspule 12 mit dem externen Steuerbefehl 29 zu prüfen.

Die Steuereinheit 20 ist auch mit einer Messvorrichtung 38 verbunden, die Messdaten 39 sendet. Die Messdaten 39 umfassen eine Größe, die den Betriebszustand der Stromversorgung der Magnetspule 12 abbildet. Die entsprechende Größe in den Messdaten 39 wird in der Steuereinheit 20 mit einem einstellbaren Sollwert verglichen. Der Sollwert wird durch einen Datensatz 42 eingestellt, der einen Konfigurationsdatensatz und/oder einen Parametersatz umfasst. Wenn die erfasste Größe betragsmäßig um mehr als einen wählbaren Toleranzwert vom einstellbaren Sollwert abweicht, wird durch die Steuereinheit 20 ein nicht bestimmungsgemäßer Zustand in der Stromversorgung der Magnetspule 12 identifiziert. Der Toleranzwert ist auch über den Datensatz 42 einstellbar. Wenn ein nicht bestimmungsgemäßer Zustand der Stromversorgung der Magnetspule 12 identifiziert ist, wird durch die Steuereinheit 20 ein Abschaltbefehl 27 an eine zweite Schaltvorrichtung 23 gesendet. Gleichzeitig wird von der Steuereinheit 20 ein korrespondierender Abschaltbefehl an die erste Schaltvorrichtung 22 in Form eines entsprechenden Signals 31 an den Signalgenerator 37 gesendet. Die erfasste Größe ist beispielsweise eine Stromstärke der Stromversorgung der Magnetspule 12. Die zweite Schaltvorrichtung 23 ist in einem Freilaufkreis 33 angeordnet und dazu geeignet, die Magnetspule 12 stromlos zu schalten. Dazu umfasst die zweite Schaltvorrichtung 23 einen Halbleiterschalter 34. Das Trennen der Stromversorgung der Magnetspule 12 erfolgt mittels eines Deaktivierungsbefehls 25 der zweiten Schaltvorrichtung 23.

Die Steuereinheit 20 ist über die Messdaten 39 der Messvorrichtung 38 dazu in der Lage, nach dem Ausgeben eines Deaktivierungsbefehls 25 durch die erste Schaltvorrichtung 22, dessen erfolgreiche Umsetzung zu verifizieren. Wenn nach dem Ausgeben eines Deaktivierungsbefehls 25 durch die erste Schaltvorrichtung 22 eine mit der Messvorrichtung 38 erfasste Größe, beispielsweise die Stromstärke, einen betätigten, also aktiven Zustand der Magnetspule 12 anzeigt, ist die Steuereinheit 20 dazu ausgebildet, einen entsprechenden Abschaltbefehl 27 an die zweite Schaltvorrichtung 23 zu senden. Der Abschaltbefehl 27 von der Steuereinheit 20 wird in der zweiten Schaltvorrichtung 23 in einen entsprechenden Deaktivierungsbefehl 25 umgesetzt, mit dem die Magnetspule 12 stromlos geschaltet wird. Der Freilaufkreis 33 mit der zweiten Schaltvorrichtung 23 bildet damit eine Rückfallebene für den Fall, dass über die erste Schaltvorrichtung 22 allein keine ordnungsgemäße Deaktivierung der Magnetspule 12 gewährleistbar ist. Das sicherheitsgerichtete Schaltgerät 10 allein bietet ein Sicherheits-Integritäts-Level von bis zu SIL2, ein Performance-Level von bis zu PLc und eine Sicherheitskategorie von bis zu 2. Die SIL-Anspruchsgrenze des sicherheitsgerichteten Schaltgeräts 10 weist ferner eine SIL-Anspruchsgrenze von bis zu SIL CL2 auf.

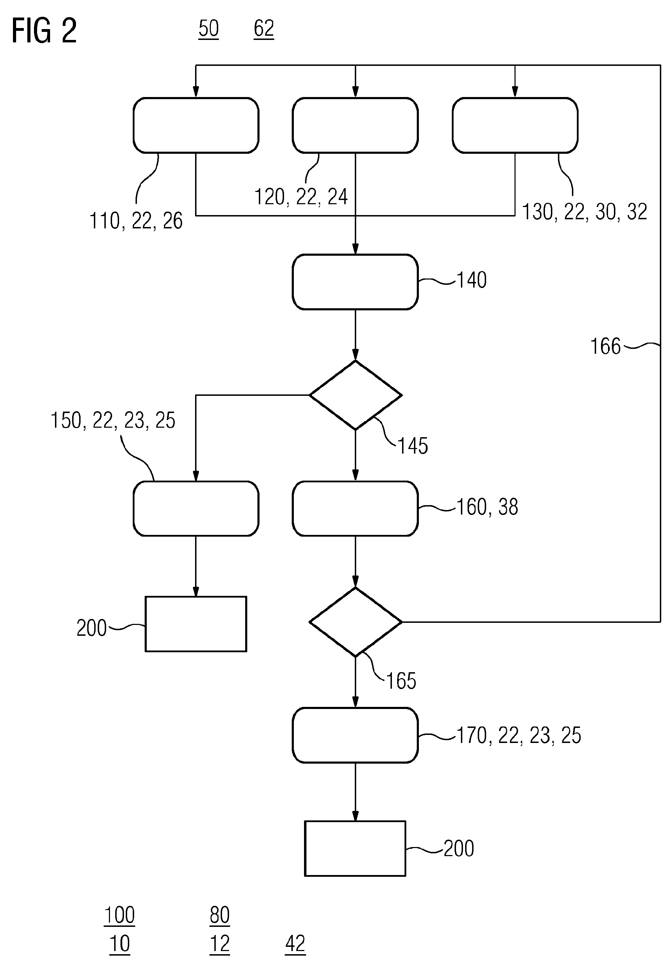

FIG 2 zeigt schematisch den Ablauf eines Betriebsverfahrens 100 für ein nicht näher abgebildetes sicherheitsgerichtetes Schaltgerät 10, das dazu ausgelegt ist, einen Lastkreis 50 zu öffnen oder zu schließen. In einem ersten Verfahrensschritt 110 wird von einer Schaltvorrichtung 22 im sicherheitsgerichteten Schaltgerät 10 ein erstes übergeordnetes Steuersignal 26 empfangen, das von einer übergeordneten Steuerinstanz 62 gesendet wird. In einem weiteren Verfahrensschritt 120, der im Wesentlichen parallel zum ersten Verfahrensschritt 110 abläuft, wird von der ersten Schaltvorrichtung 22 ein Spulensteuersignal 24 empfangen, das mittels einer Steuereinheit 20 des sicherheitsgerichteten Schaltgeräts 10 erzeugt wird. Ferner wird in einem dritten Verfahrensschritt 130, der im Wesentlichen gleichzeitig mit dem ersten und zweiten Verfahrensschritt 110, 120 abläuft, wird ein Überwachungssignal 32 von der ersten Schaltvorrichtung 22 empfangen. Das Überwachungssignal 32 stellt die Rückmeldung einer Funktionsüberwachung der Steuereinheit 20 dar. Dazu wird die Steuereinheit 20 von einem Watchdog 30 dahingehend überwacht, ob deren bestimmungsgemäße Funktion weiterhin vorliegt. Das Überwachungssignal 32 bildet binär ab, ob ein bestimmungsgemäßer Betriebszustand der Steuereinheit 20 vorliegt oder nicht. Im einem anschließenden vierten Verfahrensschritt 140 werden die vorliegenden Signale, also das erste übergeordnete Steuersignal 26, das Spulensteuersignal 24 und das Überwachungssignal 32 dahingehend geprüft, ob mindestens eines davon anzeigt, dass eine Deaktivierung der Magnetspule 12 geboten ist. Dies ist beispielsweise der Fall, wenn durch das erste übergeordnete Steuersignal 26 ein Trennen des Lastkreises 50 befohlen wird. Ergänzend oder alternativ ist eine Deaktivierung der Magnetspule 12 geboten, wenn ein Befehl von der Steuereinheit 20 ein Trennen des Lastkreises 50 vorgibt oder das Überwachungssignal 32 anzeigt, dass die Steuereinheit 20 nicht bestimmungsgemäß arbeitet.

Abhängig von Resultat des vierten Verfahrensschritts 140 ergibt sich eine erste Verzweigung 145 des Betriebsverfahrens 100. Wenn mindestens eines der Signale 24, 26, 32 eine Deaktivierung der Magnetspule 12 vorgibt, wird in einem fünften Verfahrensschritt 150 von der ersten und zweiten Schaltvorrichtung 22, 23 ein Deaktivierungsbefehl 25 an die Magnetspule 12 ausgegeben. Nach dem dadurch eintretenden Trennen des Lastkreises 50 stellt sich ein stabiler Endzustand 200 ein. Wenn sämtliche Signale 24, 26, 32 weiterhin eine Aktivierung der Magnetspule 12 gebieten erfolgt ein sechster Verfahrensschritt 160, in den mittels einer Messvorrichtung 38 ein Stromfluss durch die Magnetspule 12 erfasst wird. Im sechsten Verfahrensschritt 160 wird der erfasste Stromfluss mit einem einstellbaren Sollwert verglichen. In Abhängigkeit vom Ergebnis des Vergleichs zwischen dem einstellbaren Sollwert und dem erfassten Stromfluss ergibt sich für das erfindungsgemäße Verfahren 100 eine zweite Verzweigung 165. Wenn eine Auswertung des Vergleichs im Schritt 160 einen ordnungsgemäßen Betrieb des sicherheitsgerichteten Schaltgeräts 10 ergibt, erfolgt eine Rückführung 166 in den Ausgangszustand im ersten Verfahrensschritt 110.

Wenn der Vergleich im sechsten Verfahrensschritt 160 einen nicht bestimmungsgemäßen Zustand des Schaltgeräts 10 ergibt, folgt ein siebter Verfahrensschritt 170. Darin wird über die Steuereinheit 20 ein Deaktivierungsbefehl 25 von der ersten und zweiten Schaltvorrichtung 22, 23 an die Magnetspule 12 ausgegeben. Hierdurch erfolgt ein Trennen des Lastkreises 50, so dass als Resultat ein stabiler Endzustand 200 vorliegt.

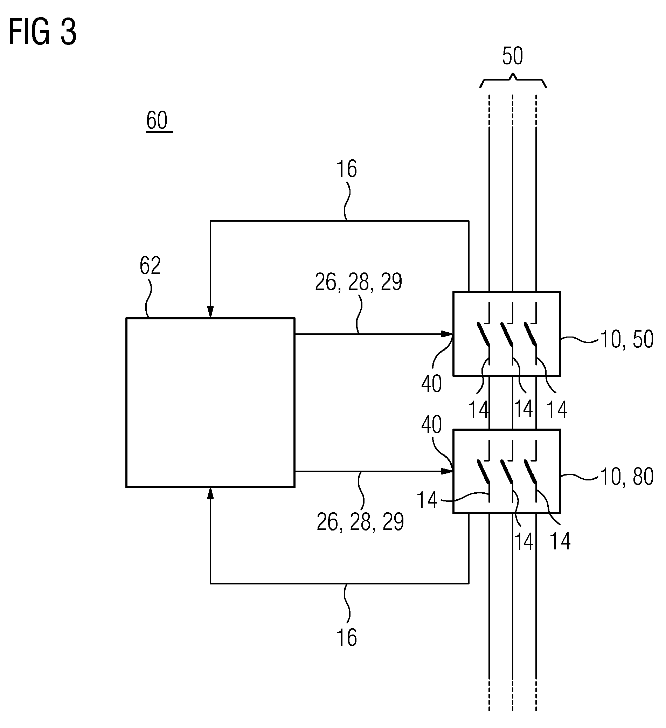

In FIG 3 ist der Aufbau eines erfindungsgemäßen Schaltsystems 60 dargestellt, das eine übergeordnete Steuerinstanz 62 aufweist, die dazu eingesetzt wird, einen Lastkreis 50 zu öffnen und zu schließen. Der Lastkreis 50 ist exemplarisch als dreiphasige Stromversorgung abgebildet. Die übergeordnete Steuerinstanz 62 ist kommunikativ mit zwei sicherheitsgerichteten Schaltgeräten 10 verbunden, die dazu ausgebildet sind, den Lastkreis 50 unabhängig voneinander zu unterbrechen. In jedem der sicherheitsgerichteten Schaltgeräte 10 ist ein Programm 80 gespeichert, das jeweils dazu ausgebildet ist, das erfindungsgemäße Betriebsverfahren 100 auf den sicherheitsgerichteten Schaltgeräten 10 umzusetzen. Die sicherheitsgerichteten Schaltgeräte 10 werden über externe Steuersignale 29 separat von der übergeordneten Steuerinstanz 62 angesteuert, wobei die externen Steuersignale 29 jeweils ein erstes und ein zweites übergeordnetes Steuersignal 26, 28 umfassen. Die externen Steuersignale 29 werden von einer Empfangseinheit 40 empfangen, die das erste und zweite übergeordnete Steuersignal 26, 28 den sicherheitsgerichteten Schaltgeräten jeweils in geeigneter Form bereitstellen. Der Schaltzustand der Schaltkontakte 14, die den Lastkreis 50 öffnen und schließen, wird in den sicherheitsgerichteten Schaltgeräten 10 separat jeweils mittels Hilfskontakten 16 an die übergeordnete Steuerinstanz 62 zurückgemeldet. Durch das serielle Kombinieren der beiden sicherheitsgerichteten Schaltgeräte 10 wird im erfindungsgemäßen Schaltsystem 60 eine Hardware-Fehlertoleranz von Eins erreicht. Das Schaltsystem 60 weist auch ein Sicherheits-Integritäts-Level von bis zu SIL 3 und ein Performance-Level von bis zu PLe auf. Ferner bietet das Schaltsystem 60 gemäß FIG 3 eine Sicherheitskategorie 4.

## Patentansprüche

1. Sicherheitsgerichtetes Schaltgerät (10) mit einer Magnetspule (12), einer Steuereinheit (20) und einer ersten Schaltvorrichtung (22), wobei die erste Schaltvorrichtung (22) zu einer Aktivierung und Deaktivierung der Magnetspule (12) ausgebildet ist, **dadurch gekennzeichnet, dass** die erste Schaltvorrichtung (22) zum Empfangen eines Spulensteuersignals (24), eines Überwachungssignals (32) und eines ersten übergeordneten Steuersignals (26) ausgebildet ist.

2. Sicherheitsgerichtetes Schaltgerät (10) nach Anspruch 1, **dadurch gekennzeichnet, dass** das das sicherheitsgerichtete Schaltgerät (10) eine zweite Schaltvorrichtung (23) aufweist, die einen Freilaufkreis (33) ausbildet, der mit der Steuereinheit (20) verbunden ist und zu einer Aktivierung und Deaktivierung der Magnetspule (12) ausgebildet ist.

3. Sicherheitsgerichtetes Schaltgerät (10) nach Anspruch 1 oder 2, **dadurch gekennzeichnet, dass** das sicherheitsgerichtete Schaltgerät (10) eine Empfangseinheit (40) zum Empfangen eines externen Steuersignals (29) aufweist, und die Empfangseinheit (40) dazu ausgebildet ist, das erste und/oder zweite übergeordnete Steuersignal (26, 28) aus dem externen Steuersignal (29) zu erzeugen.

4. Sicherheitsgerichtetes Schaltgerät (10) nach einem der Ansprüche 1 bis 3, **dadurch gekennzeichnet, dass** die erste Schaltvorrichtung (22) dazu ausgebildet ist, die Magnetspule (12) zu deaktivieren, wenn zumindest durch das erste übergeordnete Steuersignal (26), das Spulensteuersignal (24) oder das Überwachungssignal (32) eine Spulendeaktivierung vorgegeben ist.

5. Sicherheitsgerichtetes Schaltgerät (10) nach einem der Ansprüche 2 bis 4, **dadurch gekennzeichnet, dass** die zweite Schaltvorrichtung (23) zu einer Deaktivierung der Magnetspule (12) ausgebildet ist, wenn im Freilaufkreis (33) eine vorliegende Stromstärke betragsmäßig um mehr als einen wählbaren Toleranzwert von einem Sollwert abweicht.

6. Sicherheitsgerichtetes Schaltgerät (10) nach einem der Ansprüche 1 bis 5, **dadurch gekennzeichnet, dass** die erste Schaltvorrichtung (22) einen Haltleiterschalter (34), insbesondere einen IGBT oder einen MOSFET, und/oder mindestens einen Logikbaustein (36) umfasst.

7. Sicherheitsgerichtetes Schaltgerät (10) nach einem der Ansprüche 1 bis 6, **dadurch gekennzeichnet, dass** das Spulensteuersignal (24) als Pulsweitenmodulationssignal ausgebildet ist, und/oder das Überwachungssignal (32) als Ausgangssignal eines mit der Steuereinheit (20) verbundenen Watchdogs (30) ausgebildet ist.

8. Sicherheitsgerichtetes Schaltgerät (10) nach einem der Ansprüche 2 bis 7, **dadurch gekennzeichnet, dass** die zweite Schaltvorrichtung (23) einen Halbleiterschalter, insbesondere einen IGBT oder MOSFET, und/oder mindestens einen Logikbaustein umfasst.

9. Sicherheitsgerichtetes Schaltgerät (10) nach einem der Ansprüche 3 bis 8, **dadurch gekennzeichnet, dass** über die Magnetspule (12) ein Lastkreis (50) mit einer Leistung von 50 bis 750 kW unterbrechbar ist.

10. Betriebsverfahren (100) für ein sicherheitsgerichtetes Schaltgerät (10) zum Schalten eines Lastkreises (50) mittels einer Magnetspule (12), das eine Steuereinheit (20) und eine erste Schaltvorrichtung (22) aufweist, umfassend die Schritte:
a) Empfangen eines ersten übergeordneten Steuersignals (26) durch die erste Schaltvorrichtung (22);
b) Empfangen eines Spulensteuersignal (24) durch die erste Schaltvorrichtung (20), wobei das Spulensteuersignal (24) von der Steuereinheit (20) gesendet wird;
c) Empfangen eines Überwachungssignals (32) durch die erste Schaltvorrichtung (20), wobei das Überwachungssignal (32) von einem Watchdog (30) gesendet wird, der die Steuereinheit (20) überwacht;
d) Senden eines Deaktivierungsbefehls (25) von der ersten Schaltvorrichtung (22) an die Magnetspule (12), wenn in mindestens einem der Schritte a) bis c) ein Signal (24, 26, 32) empfangen wird, das eine Deaktivierung der Magnetspule (12) vorgibt.

11. Betriebsverfahren (100) nach Anspruch 10, **dadurch gekennzeichnet, dass** die Steuereinheit (20) ein zweites übergeordnetes Steuersignal (28) empfängt und ein damit korrespondierendes Spulensteuersignal (24) an die erste Schaltvorrichtung (22) sendet.

12. Betriebsverfahren (100) nach Anspruch 11, ferner umfassend die Schritte:
e) Erfassen eines Stromflusses durch die Magnetspule (12) mittels einer Messvorrichtung (38) nach Ablauf einer wählbaren Zeitdauer;
f) Senden eines Deaktivierungsbefehls (25) an die erste und/oder zweite Schaltvorrichtung (22, 23) zur Unterbrechung einer Stromversorgung der Magnetspule (12), wenn der in Schritt e) erfasste Stromfluss von einem einstellbaren Sollwert abweicht.

13. Schaltsystem (60) zum Schalten eines Lastkreises (50), umfassend eine übergeordnete Steuerinstanz (62), die zum Ausgeben eines einkanaligen oder zweikanaligen externen Steuersignals (29) ausgebildet ist, wobei das Schaltsystem (60) eine Hardware-Fehlertoleranz von mindestens Eins aufweist und mit zwei sicherheitsgerichteten Schaltgeräten (10) verbunden ist, **dadurch gekennzeichnet, dass** die sicherheitsgerichteten Schaltgeräte (10) jeweils nach einem der Ansprüche 1 bis 9 ausgebildet ist.

14. Programm (80) zur Speicherung und Durchführung in einer Steuereinheit (20) in einem sicherheitsgerichteten Schaltgeräts (10), **dadurch gekennzeichnet, dass** das Programm (80) zur Durchführung mindestens einer der Betriebsverfahren (100) nach Anspruch 10 bis 12 ausgebildet ist.
